# DEMANDE DE BREVET EUROPEEN

(11) **EP 1 132 955 A1**
(43) Date de publication de la demande: **12.09.2001**
(21) Numéro de dépôt: 01400507.8
(22) Date de dépôt: 28.02.2001
(51) Int. Cl.: H01L 21/331

(54) **Procédé de fabrication d'un transistor bipolaire double-polysilicium autoaligné.**

(30) Priorité: 06.03.2000 FR 0002855
(71) Demandeur: STMicroelectronics S.A., 94250 Gentilly (FR)
(72) Inventeur: Chantre, Alain, 38180 Seyssins (FR); Marty, Michel, 38760 Varces (FR); Baudry, Hélène, 38100 Grenoble (FR)
(74) Mandataire: Casalonga, Axel

(57) **Abrégé**

Le procédé consiste à former successivement sur une région de base d'un substrat semi-conducteur une couche de poly Ge ou poly SiGe, une couche d'arrêt de gravure sur une zone choisie de la couche de Ge ou SiGe, une couche de poly Si de même type de conductivité que la région de base, puis une couche externe de matériau diélectrique, à graver les couches en s'arrêtant sur la couche d'arrêt, pour former une ébauche de fenêtre d'émetteur, éliminer le film d'arrêt et éliminer sélectivement la couche de Ge ou SiGe dans l'ébauche de fenêtre d'émetteur pour former une fenêtre d'émetteur et former un émetteur en poly Si de type de conductivité opposé à la région de base dans la fenêtre.

Application aux technologies BiCMOS.

## Description

La présente invention concerne d'une manière générale un procédé de fabrication d'un transistor bipolaire du type double-polysilicium, c'est-à-dire dont l'émetteur et la base extrinsèque sont en silicium polycristallin (poly Si), par opposition aux transistors bipolaires simple-polysilicium dont seul l'émetteur est en poly Si.

Plus particulièrement, la présente invention concerne un procédé de fabrication d'un transistor bipolaire double-polysilicium auto-aligné ayant une base épitaxiée.

Le procédé classique de fabrication d'un transistor bipolaire double-polysilicium consiste tout d'abord, comme le montre la figure la, à former dans ou sur un substrat semi-conducteur 1 ayant un premier type de conductivité, par exemple un substrat en silicium monocristallin ayant une conductivité de type n, une région 2 ayant un second type de conductivité opposé au premier, par exemple une région en silicium et/ou alliage SiGe de conductivité de type p. On forme ainsi dans le substrat 1, une région de base 2 du second type de conductivité (p) et une région de collecteur sous-jacente à la région de base 2 et du premier type de conductivité (n).

L'étape suivante consiste à former sur la région de base 2, une première couche épaisse 3 en poly Si du second type de conductivité (par exemple une couche fortement dopée p⁺), et sur cette couche épaisse de poly Si 3, une couche épaisse d'un matériau diélectrique 4 tel que du SiO₂ ou une bicouche SiO₂/Si₃N₄.

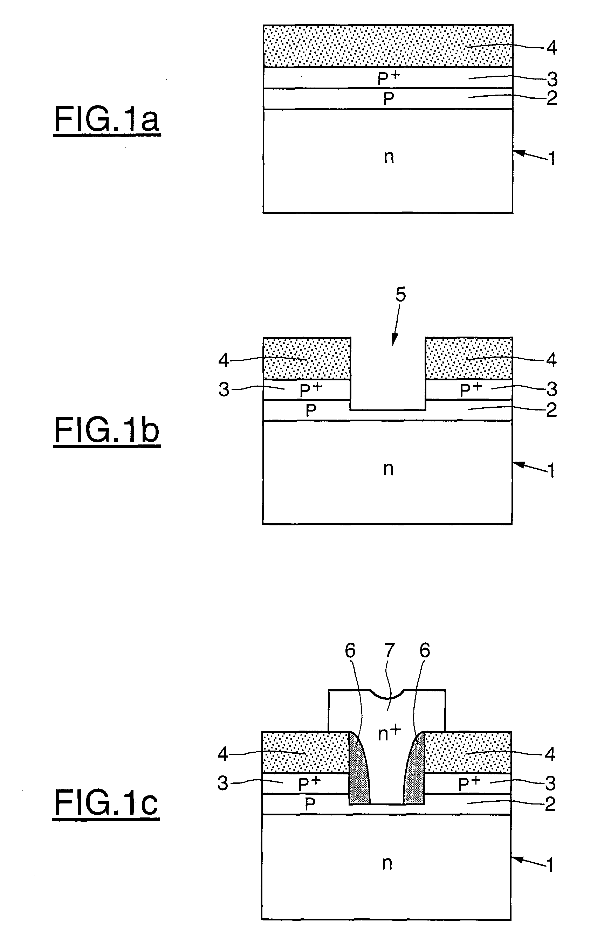

On forme alors par gravure photolithographique classique dans la couche 4 de matériau diélectrique, la couche épaisse de poly Si 3 et jusque dans la région de base 2 une fenêtre d'émetteur 5 (figure 1b).

Comme le montre la figure lc, après dépôt d'une couche de passivation 6 sur les parois latérales de la fenêtre 5, on remplit la fenêtre 5 et on revêt la couche de matériau diélectrique 4 avec une deuxième couche de poly Si du premier type de conductivité (par exemple fortement dopé n⁺) pour, après masquage et gravure classique, former une région d'émetteur 7 en poly Si de géométrie et dimension voulues. Le reste de la première couche épaisse de poly Si 3 dopée p⁺ forme la région de base extrinsèque du transistor, cependant que la partie restante de la mince couche 2 de silicium ou alliage SiGe située sous la région d'émetteur 7, forme la région de base intrinsèque du transistor bipolaire.

Le dopage des différentes couches peut se faire classiquement, soit in situ, c'est-à-dire lors de la formation des couches, soit après formation des couches par implantation ionique. De manière classique également, on peut soumettre les différentes couches dopées à des recuits d'activation des dopants.

En outre, la région de base 2 peut être constituée classiquement d'une bicouche SiGe/Si monocristalline.

La gravure de la fenêtre 5 comprend généralement une première étape classique de gravure de la couche de matériau diélectrique 4, par exemple SiO₂, avec arrêt sur la première couche de poly Si 3, puis une seconde étape de gravure, également classique, de la première couche épaisse de poly Si 3 avec arrêt dans la région de base 2 (surgravure). Cette surgravure peut pratiquement avoir pour résultat l'enlèvement de la région de base active du transistor, et donc conduire à un dispositif défectueux.

L'invention a donc pour objet un procédé de fabrication d'un transistor bipolaire double polysilicium, évitant tout risque de surgravure de la région de base active du transistor.

On a trouvé, selon l'invention, qu'il était possible d'éviter tout risque de surgravure de la région de base active d'un transistor bipolaire double polysilicium lors de sa fabrication grâce à un procédé qui comprend les étapes suivantes :
(a) l'obtention d'un substrat comprenant une région de collecteur d'un premier type de conductivité et une région de base d'un second type de conductivité opposé au premier;
(b) la formation sur la région de base d'une couche intermédiaire de germanium et/ou alliage SiGe (de préférence polycristallin) du deuxième type de conductivité;
(c) la formation sur une zone prédéterminée de la couche intermédiaire de Ge et/ou alliage SiGe d'un film d'arrêt de gravure;
(d) la formation sur la couche intermédiaire et le film d'arrêt de gravure d'une première couche épaisse de silicium polycristallin (poly Si) du deuxième type de conductivité;
(e) la formation sur la première couche de poly Si d'une couche externe d'un matériau diélectrique;
(f) la gravure à travers un masque approprié d'une ébauche de fenêtre dans la couche de matériau diélectrique et la première couche épaisse de polysilicium avec arrêt sur le film d'arrêt de gravure, puis l'élimination dans l'ébauche de fenêtre du film d'arrêt de gravure;
(g) l'élimination sélective dans l'ébauche de fenêtre de la couche de Ge et/ou alliage de SiGe pour former une fenêtre d'émetteur ayant un fond constitué par une zone découverte de la région de base et des parois latérales;
(h) la formation sur les parois latérales de la fenêtre d'émetteur d'une couche de passivation;
(i) la formation d'une deuxième couche de polysilicium du premier type de conductivité, de manière à remplir la fenêtre d'émetteur et recouvrir la couche externe de matériau diélectrique; et
(j) la gravure de la deuxième couche de polysilicium du premier type de conductivité pour former une région d'émetteur de géométrie et dimension voulues.

Les procédés de formation de couches de Ge et/ou alliage SiGe sont bien connus et on peut utiliser par exemple des procédés de dépôt chimique en phase vapeur (CVD) classiques.

De même, la formation des couches de polysilicium peut se faire par tout procédé classique tel que dépôt CVD et dépôt en phase vapeur assisté par plasma (PECVD).

La formation de couches en matériau diélectrique, par exemple SiO₂, Si₃N₄, telles que la couche de l'étape (f) et la couche de passivation des parois latérales de la fenêtre d'émetteur, est également classique dans la technologie des transistors bipolaires.

La couche intermédiaire de Ge et/ou SiGe de l'étape (d) a une épaisseur qui varie généralement de 2 à 125 nm et est de préférence de l'ordre de 2 à 40 nm.

La première couche de polysilicium a en général une épaisseur de 50 à 250 nm, de préférence de 125 nm à 250 nm.

Le dopage de ces couches s'effectue de manière classique, soit par dopage in situ avec un dopant de conductivité appropriée, soit après dépôt des couches par implantation ionique classique d'un dopant de conductivité appropriée. De manière classique, on peut procéder à des étapes de recuit pour activer les dopants.

Les alliages SiGe sont bien connus. Parmi ces alliages, on peut citer les alliages Si₁₋ₓGeₓ, 0<x<1 et les alliages Si_{1-x-y}GeₓC_{y}, 0<x≤0,95 et 0<y≤0,05.

On utilisera de préférence des alliages SiGe à teneur relativement élevée en germanium, généralement 10 à 50% atomique de germanium, car la sélectivité de gravure de l'alliage SiGe vis-à-vis du silicium et de SiO₂ croît avec la teneur en germanium de l'alliage.

Le masquage et la gravure des différentes couches pour former l'ébauche de la fenêtre d'émetteur peuvent se faire par tout procédé, tel qu'une attaque anisotropique par voie sèche, par exemple par plasma.

L'élimination sélective du film de Ge ou de SiGe peut s'effectuer de manière classique au moyen d'une chimie oxydante, par exemple avec une solution 40 ml HNO₃ 70% + 20 ml H₂O₂ + 5 ml HF 0,5 % ou par attaque plasma isotrope. Cette élimination est contrôlée de manière à ôter la partie de la couche de poly Ge ou poly SiGe située au fond de l'ébauche de fenêtre d'émetteur et éventuellement à graver une petite fraction de cette couche sous la première couche de polysilicium.

La présence du film d'arrêt de gravure, par exemple de SiO₂, permet d'arrêter avec certitude la gravure de la première couche de polysilicium, généralement réalisée par gravure plasma, sur le film d'arrêt. En effet, la gravure plasma du polysilicium est sélective par rapport au SiO₂ et on peut utiliser classiquement un signal de détection de fin d'attaque. Ainsi, on est certain, lors de la gravure de la première couche de polysilicium, de ne pas graver la couche intermédiaire jusqu'à un percement de cette couche et une éventuelle gravure ou détérioration de la région de base.

La gravure du film d'arrêt et éventuellement d'une fraction de la couche intermédiaire peut alors se faire sans risque de détérioration de la surface de la région de base, en utilisant des techniques de gravure connues, plus douces et sélectives.

La suite de la description se réfère aux figures annexées qui représentent, respectivement :
Figures 1a à 1c - des vues en coupe schématiques des principales étapes d'un procédé de fabrication d'un transistor bipolaire double polysilicium, selon l'art antérieur; et
Figures 2a à 2e - des vues en coupe schématiques des principales étapes d'une première réalisation du procédé selon l'invention; et

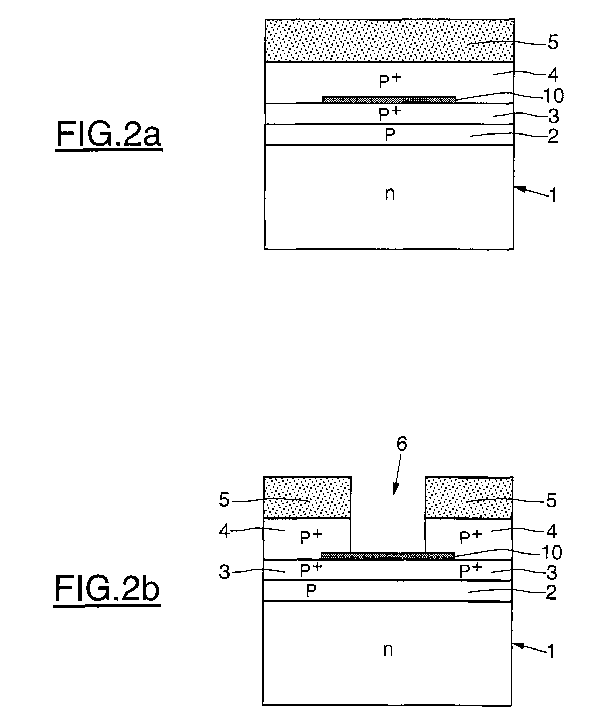

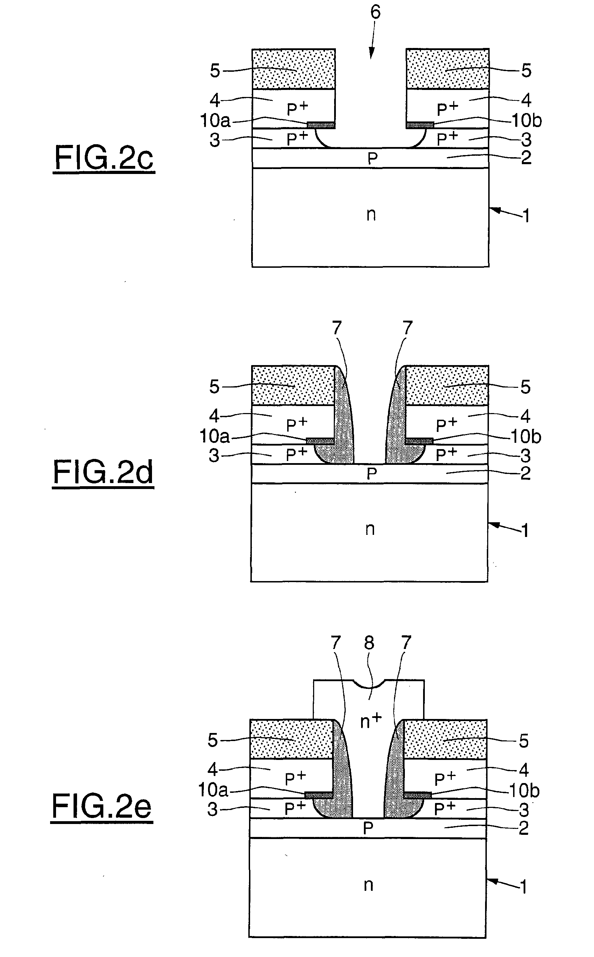

En se référant aux figures 2a à 2e, on va maintenant décrire un mode de réalisation d'un transistor bipolaire double polysilicium de structure npn, conformément au procédé de l'invention.

Bien évidemment, le procédé peut également s'appliquer à un transistor bipolaire de structure pnp.

Comme dans le procédé de l'art antérieur, le procédé débute par l'obtention d'un substrat 1 de silicium dopé n comportant une région de base 2 dopée p. Cette région de base peut être formée par dopage approprié de la région du substrat, immédiatement sous-jacente à une surface principale du substrat 1, la partie restante dopée n du substrat 1 constituant alors une région de collecteur. Cette région de base peut également être réalisée par formation sur une surface principale du substrat d'une couche de SiGe ou d'une bicouche SiGe/Si dopée de manière convenable.

On forme alors sur la région de base 2 une couche 3 en Ge ou alliage SiGe dopée p⁺. On forme de manière connue en soi sur une zone prédéterminée de la couche 3 de Ge ou SiGe un film d'arrêt 10, par exemple en SiO₂ ou Si₃N₄, puis une couche épaisse en silicium polycristallin 4 dopée p⁺, et finalement une couche 5 de SiO₂.

Généralement, le film d'arrêt 10 a une épaisseur de 10 à 50 nm.

Après masquage (non représenté), on grave la couche 5 de SiO₂ et la couche de poly Si 4, par exemple par gravure plasma anisotrope à sec, jusqu'au film d'arrêt 10 pour former une ébauche de fenêtre d'émetteur 6 (figure 2b).

Comme le montre la figure 2b, lors de cette gravure de la couche 4 de poly Si, on est sûr d'avoir gravé la totalité de la couche 4 de poly Si mais sans risque de gravure de la couche intermédiaire et par suite de la région de base 2.

Comme le montre la figure 2c, on effectue alors la gravure du film d'arrêt 10 et la gravure sélective de la couche 3 en Ge ou SiGe pour faire apparaître la surface de la région de base 2 et ainsi achever l'ouverture de la fenêtre d'émetteur 6.

Cette élimination sélective de la couche 3 de Ge ou SiGe conduit généralement à graver légèrement la couche 3 sous les parties restantes 10a, 10b du film d'arrêt et la couche de poly Si 4 de part et d'autre des parois latérales de la fenêtre d'émetteur 6.

On procède alors classiquement, comme le montre la figure 2d, à la formation sur les parois latérales de la fenêtre d'émetteur 6 d'une couche de passivation 7 en matériau diélectrique, par exemple en SiO₂ ou Si₃N₄.

Puis, on forme une deuxième couche de poly Si dopée n⁺ comblant la fenêtre d'émetteur 6 et recouvrant la couche externe de matériau diélectrique 5 qui, après masquage, est ensuite gravée de manière classique pour former la région d'émetteur 8.

Le transistor bipolaire peut alors être achevé de manière classique par formation de contacts et dépôt d'une couche d'enrobage.

Ainsi, par le procédé de l'invention, on forme un transistor bipolaire double-polysilicium auto-aligné sans risque de surgravure de la région de base 2.

## Revendications

1. Procédé de fabrication d'un transistor bipolaire double-polysilicium auto-aligné, **caractérisé en ce qu'**il comprend les étapes suivantes :
(a) l'obtention d'un substrat de silicium (1) comprenant une région de collecteur d'un premier type de conductivité et une région de base (2) d'un second type de conductivité opposé au premier;
(b) la formation sur la région de base (2) d'une couche intermédiaire (3) en Ge et/ou SiGe ayant le second type de conductivité;
(c) la formation sur une zone prédéterminée de la couche intermédiaire (3) d'un film d'arrêt de gravure (10).
(d) la formation sur la couche intermédiaire (3) et le film d'arrêt de gravure (10) d'une première couche épaisse (4) en poly Si du second type de conductivité;
(e) la formation sur la première couche (4) de poly Si d'une couche externe d'un matériau diélectrique;
(f) la gravure à travers un masque approprié de la couche externe de matériau diélectrique et de la première couche épaisse (4) de poly Si avec arrêt sur le film d'arrêt de gravure (10), puis l'élimination de la partie correspondante du film d'arrêt de gravure;
(g) l'élimination sélective de la couche de Ge et/ou SiGe pour former une fenêtre d'émetteur (6) ayant un fond constitué par une zone découverte de la région de base (2) et des parois latérales;
(h) la formation sur les parois latérales de la fenêtre d'émetteur (6) d'une couche de passivation (7);
(i) la formation d'une deuxième couche de poly Si du premier type de conductivité, de manière à remplir la fenêtre d'émetteur (6) et recouvrir la couche externe (5) de matériau diélectrique; et
(j) la gravure à travers un masque approprié de la deuxième couche de poly Si du premier type de conductivité pour former une région d'émetteur (8) de géométrie et dimension voulues.

2. Procédé selon la revendication 1, **caractérisé en ce que** le film d'arrêt est un film en matériau diélectrique.

3. Procédé selon la revendication 2, **caractérisé en ce que** le film d'arrêt est un film de SiO₂ ou Si₃N₄.

4. Procédé selon l'une quelconque des revendications 1 à 3 **caractérisé en ce que** le film d'arrêt a une épaisseur de 10 à 50 nm.

5. Procédé selon l'une quelconque des revendications 1 à 4, **caractérisé en ce que** la couche (3) de Ge et/ou SiGe a une épaisseur de 20 à 125 nm, de préférence de l'ordre de 50 nm.

6. Procédé selon l'une quelconque des revendications précédentes, **caractérisé en ce que** la première couche épaisse (4) de poly Si du second type de conductivité a une épaisseur de 50 à 250 nm, de préférence de 125 à 250 nm.

7. Procédé selon l'une quelconque des revendications précédentes, **caractérisé en ce que** l'alliage SiGe contient de 10 à 50% atomique de germanium.

8. Procédé selon l'une quelconque des revendications précédentes, **caractérisé en ce que** la couche externe de matériau diélectrique (5) est du SiO₂.

9. Procédé selon l'une quelconque des revendications précédentes, **caractérisé en ce que** la couche de passivation (7) est en SiO₂ ou Si₃N₄.
